# EUROPÄISCHE PATENTSCHRIFT

(11) **EP 0 765 013 B1**
(45) Veröffentlichungstag und Bekanntmachung des Hinweises auf die Patenterteilung: **02.04.2003**
(21) Anmeldenummer: 96114719.6
(22) Anmeldetag: 13.09.1996
(51) Int. Cl.: H01S 5/026, G02B 6/42

(54) **Optoelektronische Sende-Empfangs-Vorrichtung**
Optoelectronic transceiver
Emetteur-récepteur optoélectronique

(30) Priorität: 20.09.1995 DE 19534936
(43) Veröffentlichungstag der Anmeldung: 26.03.1997
(73) Patentinhaber: Infineon Technologies AG, 81669 München (DE)
(72) Erfinder: Stein, Karl-Ulrich, Dr., 82008 Unterhaching (DE)
(74) Vertreter: Müller, Wolfram Hubertus, Dipl.-Phys.

(56) Entgegenhaltungen:
- EP-A- 0 495 559
- WO-A-88/05970
- WO-A-94/11930
- US-A- 3 952 265
- US-A- 5 031 188
- PATENT ABSTRACTS OF JAPAN vol. 010, no. 264 (P-495), 9.September 1986 & JP-A-61 090108 (NEC CORP), 8.Mai 1986,

## Beschreibung

Die Erfindung bezieht sich auf eine optoelektronische Sende-Empfangs-Vorrichtung, die insbesondere als Sende-Empfangs-Wandler für einen Halb-Duplex-Betrieb eingesetzt werden kann.

Nachdem in der Nachrichtenübertragungstechnik das Medium Glasfaser (Lichtwellenleiter) im Fernlängennetz und Verbindungsliniennetz das Kupferkabel weitgehend abgelöst hat, ist die Einführung der Glasfasertechnik im Teilnehmeranschlußbereich eine wichtige nachrichtentechnische Aufgabe der kommenden Jahre. Der Teilnehmeranschlußbereich stellt den kostenintensivsten Bereich der Fernmeldenetze dar. Diese Tatsache führt zu einem Bestreben der Netzbetreiber nach einer im Vergleich zur Kupferleitung kostenneutralen und gleichzeitig zukunftsicheren Lösung. Derzeit werden unterschiedliche Gestaltungsmöglichkeiten für eine Übertragungsarchitektur im Teilnehmeranschlußbereich untersucht. Bei einer als möglicherweise besonders aussichtsreich angesehenen Architektur erfolgt die Übertragung zwischen einem vermittlungsseitigen Endgerät (OLT = Optical Line Termination) und mehreren teilnehmerseitigen Netzabschlüssen (ONU = Optical Network Unit) in der Form eines Sternnetzes mit passiver Verteilung, welches bei einer realisierbaren Anschlußleitungslänge von etwa 10 km eine vorteilhafte Konzentration der Teilnehmeranzahl auf eine Vermittlungsstelle darstellt. Bei dieser Gestaltungsmöglichkeit für eine Punkt-zu-Multipunkt-Verbindung kann bei einer bevorzugten Verteilstruktur die Glasfaser bis zur Wohnung des Teilnehmers geführt werden (FTTH, Fiber to the Home, d.h. der teilnehmerseitige Netzabschluß ONU befindet sich in der Wohnung). Als Übertragungsverfahren eignet sich bei einer solchen Architektur beispielsweise das sogenannte TDM/TDMA-Verfahren (Time Division Multiplexing/Time Division Multiple Access). In Richtung zum Teilnehmer (Downstream) wird ein Zeitmultiplex-Rahmen zu allen ONU's übertragen (TDM). Die einzelnen ONU's greifen dann auf ihre Kanäle in dem vollständig empfangenen Rahmen zu. In Richtung vom Teilnehmer (Upstream) senden die einzelnen ONU's in vorgeschriebener Reihenfolge ihre Datenbursts zu der OLT (TDMA).

Für Datenraten bis in den Bereich von 150 und mehr Megabit pro Sekunde ist ein Halb-Duplex-Betrieb vorteilhaft, bei dem an einem Ende des Lichtwellenleiters zeitlich nacheinander gesendet bzw. empfangen wird. Optoelektronische Sende-Empfangs-Wandler für den Betrieb am Ende eines Lichtwellenleiters befinden sich noch im Frühstadium ihres Einsatzes. Ihre Kosten sind jedoch von wesentlicher Bedeutung für die Ausbreitung des Konzeptes Faser bis zum Teilnehmer (FTTH). Insbesondere für Datenraten im angegebenen Bereich erlaubt ein Halb-Duplex-Betrieb bzw. sogenannter Ping-Pong-Betrieb, bei dem an einem Ende zeitlich nacheinander gesendet bzw. empfangen wird, möglicherweise einen kostengünstigeren Aufbau des Sende-Empfangs-Moduls als bei Voll-Duplex-Betrieb.

Aus der EP A 0 495 559 ist ein mit einer optischen Faser gekoppelter Halbleiterlaser bekannt, bei dem zwischen der optischen Faser und der Lichtaustrittsfläche des Halbleiterlasers ein Indexanpassungsmedium in Form eines Epoxidharzes vorgesehen ist.

Aus der US A 5 031 188 ist eine optoelektronische Sende-Empfangs-Vorrichtung nach dem Oberbegriff des Anspruchs 1 bekannt.

Aus Patent Abstracts of Japan VOL. 010, No. 264(P-495), 9. September 1986 & JP-A-61 090108 ist eine Kopplungsanordnung zwischen einer Laserdiode und einer optischen Faser in Form eines Anpassmaterials bekannt, dessen Brechungsindex größer ist als der von Luft und kleiner ist als der äquivalente Brechungsindex des aktiven Wellenleiters der Laserdiode.

Der Erfindung liegt die Aufgabe zugrunde, eine einfach herzustellende, insbesondere monolithisch integriert ausgebildete, optoelektronische Sende-Empfangs-Vorrichtung für einen Halb-Duplex-Betrieb zur Verfügung zu stellen, welche sowohl hinsichtlich der Empfangseigenschaften, insbesondere im Hinblick auf den Wirkungsgrad im Empfangsbetrieb, als auch hinsichtlich der Sendeeigenschaften, insbesondere im Hinblick auf den Wirkungsgrad im Sendebetrieb, zufriedenstellend arbeitet.

Diese Aufgabe wird durch eine optoelektronische Sende-Empfangs-Vorrichtung nach Anspruch 1 gelöst.

Erfindungsgemäß ist vorgesehen, daß die Ankopplung des Lichtwellenleiters an die im Halbleiterchip monolithisch integriert ausgebildete Halbleiterlaser- und Empfangsdiode derart ausgebildet und die lichtwellenleiterseitige Begrenzungsfläche des Halbleiterchips so beschaffen ist, daß bei einem für die ausreichende Gewährleistung der Laserfunktion erforderlichen hinreichend geringen Reflexionsgrad der vom Laser ausgesandten Laserstrahlung ein möglichst hoher Anteil der über den Lichtwellenleiter empfangenen Strahlung in die Halbleiterlaser- und Empfangsdiode einfällt. Hierbei kann in Weiterführung der erfindungsgemäßen Lösung vorgesehen sein, daß die lichtwellenleiterseitige Begrenzungsfläche des Halbleiterchips eine im wesentlichen fast annähernd vollständig entspiegelte Oberfläche bzw. eine eine im wesentlichen fast annähernd vollständige optische Durchlässigkeit für die über den Lichtleiter empfangene Strahlung aufweisende Oberfläche besitzt. Die erfindungsgemäße Verbesserung einer optoelektronischen Sende-Empfangs-Vorrichtung besteht somit im wesentlichen darin, die der Faser zugewandte Seite des Lasers, der insbesondere einen Fabry-Perot-Typ darstellt, soweit für eine hinreichend zulässige Laserfunktion zu entspiegeln, so daß die ankommende Empfangsleistung möglichst vollständig in den Laserkanal gerät.

Der Lichtwellenleiter bzw. die Faser ist möglichst gut an die Sende-Empfangs-Vorrichtung angekoppelt. Zu diesem Zweck ist insbesondere vorgesehen, daß der Ankopplung des Lichtwellenleiters an die lichtwellenleiterseitige Begrenzungsfläche des Halbleiterchips eine dünne, auf einer dem Lichtwellenleiter zugewandten Oberfläche der lichtwellenleiterseitigen Begrenzungsfläche des Halbleiterchips aufgebrachte Anpassungsschicht zugeordnet ist, welche Anpassungsschicht so beschaffen bzw. ein solches Material aufweist, daß ein möglichst hoher Anteil der über den Lichtleiter empfangenen Strahlung in die Halbleiterlaser- und Empfangsdiode einfällt. Eine besonders günstige Ankopplung des Lichtwellenleiters im Sinne einer hohen ankommenden Empfangsleistung ergibt sich, wenn das Material der dünnen, auf die dem Lichtwellenleiter zugewandten Oberfläche der lichtwellenleiterseitigen Begrenzungsfläche des Halbleiterchips aufgebrachten Anpassungsschicht einen Brechungsindex von etwa dem geometrischen Mittel der Werte des Brechungsindex des Materials der Halbleiterlaserund Empfangsdiode und des Brechungsindex des Materials des Lichtwellenleiters besitzt. In konkreter Ausgestaltung kann beispielsweise vorgesehen sein, daß der Brechungsindex des Halbleiterchipmaterials in dem Bereich von etwa 3,3 bis etwa 3,8 liegt und der Brechungsindex des Materials des Lichtwellenleiters in dem Bereich von etwa 1,4 bis etwa 1,6 liegt .

Zusätzlich kann vorgesehen sein, daß das Material der Anpassungsschicht einen geringen optischen Absorptionskoeffizienten besitzt.

Das rückwärtige Ende des Lasers sollte hochspiegelnd sein, so daß die dem Lichtwellenleiter abgewandte Begrenzungsfläche des Halbleiterlasers mit einer für das Laserlicht hoch reflektierenden Oberfläche versehen ist.

Das Material der Anpassungsschicht kann hierbei günstigerweise so gewählt werden, daß es neben den geeigneten optischen Eigenschaften, insbesondere einen geringen Absorptionsgrad für die empfangene Strahlung auch günstige mechanische und chemische Eigenschaften besitzt. So soll das Material bevorzugtermaßen inert gegenüber den benachbarten Materialien sein, chemisch stabil sein, und eine geeignete Konsistenz derart besitzen, daß fertigungsbedingte Toleranzen ausgeglichen werden können, beziehungsweise eine mechanisch dauerhafte homogene Füllung des Raumes zwischen der äußeren Begrenzungsfläche des Halbleiterchips und dem anzukoppelnden Ende des Lichtwellenleiters gewährleistet ist.

Bei einer weiterhin bevorzugten Ausführung der Erfindung kann vorgesehen sein, daß zwischen dem lichtaussendenden Ende des Halbleiterlasers und der dem Ende des Lichtwellenleiters zugewandten Begrenzungsfläche des Halbleiterchips ein Feldtransformator zur Anpassung des optischen Lichtausgangsfeldes von den räumlichen Abmessungen der Lichtaustrittsfläche des Lasers an die Eintrittsfläche des angekoppelten Lichtwellenleiters vorgesehen ist. Ein derartiger Feldtransformator ermöglicht aufgrund der besseren Anpassung des optischen Ausgangsfeldes insgesamt eine Verringerung der abgestrahlten bzw. empfangenen Verlustleistungen. Bei einer konkreten Ausführung mit einem Durchmesser des Faserkerns von etwa 9 µm und einem geringfügig größerem Durchmesser des optischen Ausgangsfeldes von etwa 10 µm ermöglicht der Feldtransformator eine Anpassung an die Geometrie des Laserkanales mit typischen Abmessungen in der Höhe von 0,1 µm bis etwa 0,2 µm und etwa 2 µm bis 3 µm in der Breite.

Bei einer weiterhin vorteilhaften Ausführung der Erfindung kann vorgesehen sein, daß zwischen dem lichtaussendenden Ende des Halbleiterlasers und der dem Ende des Lichtwellenleiters zugewandten Begrenzungsfläche des Halbleiterchips ein Feldtransformator zur Anpassung des optischen Lichtausgangsfeldes von den räumlichen Abmessungen der Lichtaustrittsfläche des Lasers an die Eintrittsfläche des angekoppelten Lichtwellenleiters vorgesehen ist.

Bei einer besonderen Ausführungsform der Erfindung kann auf die in der Regel erforderliche Monitordiode beim Laserbetrieb dadurch verzichtet werden, daß der Leistungspegel an der Empfangsdiode am anderen Ende des Lichtwellenleiters erfaßt wird und eine gegebenenfalls erforderliche Korrekturgröße beispielsweise von Zeit zu Zeit vermittels einer Steuerzelle dem betreffenden Sender mitgeteilt wird, der über eine von einer entsprechend ausgebildeten Auswerteschaltung gelieferten Auswertung dieser Information die Sendeleistung selbsttätig nachstellt. Im Falle der Verwendung der optoelektronischen Sende-Empfangs-Vorrichtung bei einem passiven optischen Netz mit vielen Teilnehmern wird eine derartige Vorrichtung vornehmlich für die Teilnehmer in Frage kommen. Die betreffende Information über die Leistung des einzelnen Teilnehmers kann hierbei vom Amtsende aus adressiert an die einzelnen Teilnehmer abgegeben werden.

Bei einer weiterhin bevorzugten Ausführung kann für die im Halbleiterchip monolithisch integriert ausgebildete Halbleiterlaser- und Empfangsdiode ein sogenannter DFB-Laser (Distributed Feed-Back-Laser) verwendet werden, welcher sich durch einen quergeriffelten Resonator (Bragg-Gitter) auszeichnet. Grundsätzlich haben die stehenden Wellen (Moden) im Laserresonator Anteile längs (erwünscht) und quer (unerwünscht) zur Abstrahlrichtung. Wird nun das Bragg-Gitter in die aktive Zone implementiert, so bilden sich viele kleine Unterresonatoren. Die Rückkopplungsvorgänge verteilen sich. Zum einen werden die Queranteile weiter in ihrer Wirkung unterdrückt und in Längsrichtung bilden sich in den schmalen Rillen nur wenige Moden aus, zum anderen addieren bzw. löschen sich gegenläufige Wellen (Selektion). Als Folge davon erfährt die sogenannte Bragg-Wellenlänge mit Abstand die größte Schwellverstärkung (Eigenverstärkung) und der DFB-Laser arbeitet im Einmodenbetrieb. Diese Wirkungsweise des DFB-Lasers ist an sich bekannt. Bei der erfindungsgemäßen Lösung mit einem DFB-Laser kann die Ankopplung des Lichtwellenleiters wiederum durch einen monolithisch integriert im Halbleiterchip ausgebildeten Feldtransformator, sowie durch Vorsehen der geeignet gewählten Anpassungsschicht zwischen dem Ende des Lichtwellenleiters und der diesem zugewandten Begrenzungsfläche des Halbleiterchips verbessert werden, wobei die Anordnung der Ankopplung in Form einer Stoßkopplung oder in Form einer Intra-Chip-Faser-Befestigung ausgebildet sein kann.

Im Falle der Verwendung eines DBR-Lasers (Distributed Bragg Reflector-Laser), der auch als Empfangsdiode dient, ist es ebenfalls günstig, das Ende des Lasers zur Glasfaser hin niedrig reflektierend, und das andere Ende des Lasers, welches zur Glasfaser abgewandt angeordnet ist, hochreflektierend auszubilden. Bei dem an sich bekannten DBR-Laser liegt das Bragg-Gitter außerhalb der aktiven Zone, wodurch viele diskrete Resonatorlängen im Laser vorgesehen werden. Aufgrund der Bragg-Bedingung ist hierbei nur ein schmales Band von Lasermoden ausbreitungsfähig, wobei das Band umso schmäler ist, je kleiner die Periodenlänge und je größer die Tiefe der Füllung ist. Auch hier kann Einmodenbetrieb mit der Bragg-Wellenlänge erreicht werden.

Im Falle der Ausbildung mit einem DBR-Laser kann eine Monitordiode vorgesehen sein, die monolithisch integriert im Halbleiterchip ausgebildet ist.

Bei einer weiterhin vorteilhaften Ausführung der Erfindung mit vorzugsweise einer DBR-Laser- und Empfangsdiode werden zwei dicht benachbarte Wellenlängen verwendet, die innerhalb des Verstärkungsfensters des Lasers liegen, jedoch durch Gitterreflektoren getrennt werden können, beispielsweise jeweils im ersten Reflexionsminimum. Hierbei dient die erste Wellenlänge zum Senden, und die zweite Wellenlänge zum Empfangen. Im Empfangsfall passiert die zweite Wellenlänge ungedämpft die für den Laserbetrieb erforderlichen Gitterreflektoren auf beiden Seiten der Laserdiode. Zur Erhöhung des Empfangswirkungsgrades kann die Sende-Empfangs-Vorrichtung solchermaßen ausgebildet sein, daß an dem der Faser abgewandten Ende der Anordnung die zweite Wellenlänge vorteilhalfterweise durch einen Reflektor reflektiert wird.

Bei einer vergleichbaren Anordnung kann hierbei auch eine DFB-Laser- und Empfangsdiode verwendet werden.

Zur Realisierung eines Ping-Pong-Betriebes mit elektrooptischen Wandlern mit den wünschenswerten Leitungslängen von etwa 10 km und Teilnehmerzahlen am Splitter von etwa 32 erlaubt die erfindungsgemäße Sende-Empfangs-Vorrichtung eine wesentlich kostengünstigere Ausbildung insbesondere von teilnehmerseitigen elektrooptischen Sende-Empfangs-Wandlern, wie sie für die Einführung des Konzeptes Fiber to the Home, insbesondere mit PON-Struktur (passives optisches Netz) erforderlich sind.

Weitere Merkmale, Vorteile und Zweckmäßigkeiten der Erfindung ergeben sich aus der Beschreibung von Ausführungsbeispielen anhand der Zeichnung. Es zeigt:
Fig. 1 eine schematische Ansicht zur Erläuterung einer bevorzugten Anwendung einer optoelektronischen Sende-Empfangs-Vorrichtung gemäß Erfindung als optoelektronischer Teilnehmerwandler am teilnehmerseitigen Ende des Lichtwellenleiters,
Fig. 2 eine Kurve zur Erläuterung der Abhängigkeit der Transmission vom Brechungsindex des Materials der Anpassungsschicht, Fig. 3 eine schematische Schnittansicht einer optoelektronischen Sende-Empfangs-Vorrichtung gemäß einem Ausführungsbeispiel der Erfindung,
Fig. 4 eine schematische Schnittansicht einer optoelektronischen Sende-Empfangs-Vorrichtung gemäß einem weiteren Ausführungsbeispiel der Erfindung,
Fig. 5 eine schematische Schnittansicht einer optoelektronischen Sende-Empfangs-Vorrichtung gemäß einem weiteren Ausführungsbeispiel der Erfindung,
Fig. 6 eine schematische Schnittansicht einer optoelektronischen Sende-Empfangs-Vorrichtung gemäß einem weiteren Ausführungsbeispiel der Erfindung, und
Fig. 7 eine schematische Schnittansicht einer optoelektronischen Sende-Empfangs-Vorrichtung gemäß einem weiteren Ausführungsbeispiel der Erfindung.

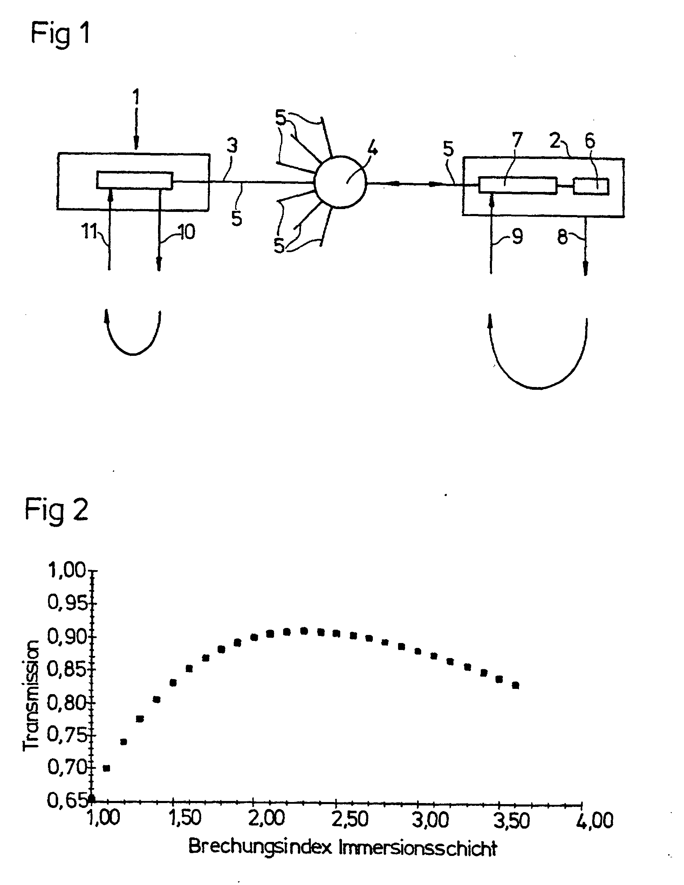

Fig. 1 zeigt in einer Schemaansicht die Anwendung einer erfindungsgemäßen optoelektronischen Sende-Empfangs-Vorrichtung 1 am teilnehmerseitigen Anschluß eines Verbindungsliniennetzes für die optische Nachrichtenübertragung in Form eines passiven optischen Netzes, bei dem die Datenübertragung zwischen einem vermittlungsseitigen Endgerät 2 und mehreren teilnehmerseitigen Netzabschlüssen 3 erfolgt, die sternförmig über einen Splitter 4 und über Lichtwellenleiter 5 zentral an das vermittlungsseitige Endgerät 2 gekoppelt sind. Das Endgerät 2 besteht aus einem Detektorteil 6 (amtsseitiger Empfänger) und einem Laserteil 7 (amtsseitiger Sender), wobei der Detektorteil 6 ein Informationssignal 8 über den analogen Teilnehmerpegel liefert, aus dem eine Stellgröße 9 in digitaler Form für den zu steuernden Laserstrom des Laserteils 7 abgeleitet wird. Bei der teilnehmerseitig angeordneten optoelektronischen Sende-Empfangs-Vorrichtung 1 mit einem monolithisch integriert ausgebildeten Sende-Empfangs-Laserchip wird aufgrund der Monitorfunktion eine digitale Stellgröße 10 für den Laserstrom abgeleitet und zur Steuerung des Sendeteils gemäß Bezugsziffer 11 zugeführt.

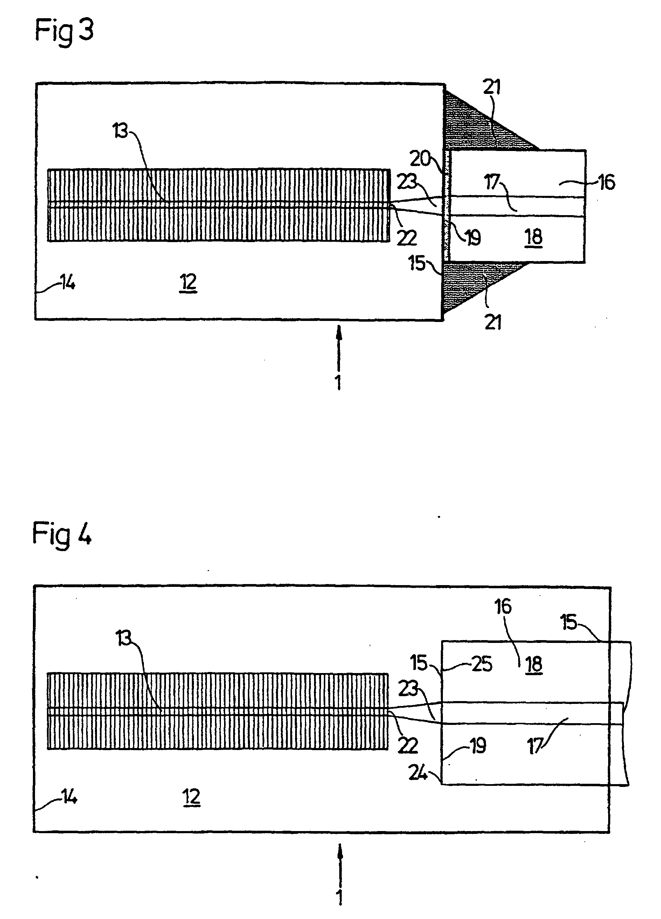

Fig. 3 zeigt ein erstes Aufführungsbeispiel einer teilnehmerseitigen optoelektronischen Sende-Empfangs-Vorrichtung 1 in näheren Einzelheiten. In einem ein InP-Substratmaterial aufweisenden Halbleiterchip 12 ist monolithisch integriert eine DFB-Halbleiterlaser- und Empfangsdiode 13 ausgebildet, dessen Laserresonator durch die beiden äußeren, einander gegenüberliegend angeordneten Begrenzungsflächen 14 und 15 des Halbleiterchips 12 ausgebildet sind. Das vom Halbleiterlaser 13 ausgesandte Laserlicht wird in einen an der lichtwellenleiterseitigen Begrenzungsfläche 15 des Halbleiterchips 12 angekoppelten Lichtwellenleiter 16 eingestrahlt. Im dargestellten Fall stellt der Lichtwellenleiter 16 eine Monomode-Faser dar mit einem Faserkern 17 aus Quarzglas. Die Ankopplung des Faserendes 18 an den Halbleiterchip 12 erfolgt in Stopkopplung mit einer zwischen der Begrenzungsfläche 15 des Halbleiterchips 12 und der stirnseitigen Begrenzungsfläche 19 des Faserendes 18 eingebrachten dünnen Anpassungsschicht 20 aus einem Material mit einem Brechungsindex, der im wesentlichen wenigstens annähernd dem geometrischen Mittel der Werte des Brechungsindex des Materials der Halbleiterlaser- und Empfangsdiode und des Brechungsindex des Materials des Lichtwellenleiters entspricht. Wie sich gemäß Fig. 2 aus der Darstellung der Abhängigkeit der Transmission von dem Brechungsindex der Anpassungsschicht 20 ergibt, liefert bei einem Brechungsindex von 1,5 für das Material des Lichtwellenleiters 16 und einem Brechungsindex von etwa 3,6 für das InP-Halbleitermaterial ein aus dem genannten geometrischen Mittel gewonnener Wert für den Brechungsindex der Anpassungsschicht eine besonders hohe Transmission des empfangenen Laserlichts. Als Material für die Anpassungsschicht 20 kommt ein optisch transparentes Kunststoffmaterial in Frage, welches neben den geforderten optischen Eigenschaften darüber hinaus günstige mechanische und chemische Eigenschaften im Hinblick auf eine einfache Herstellung und möglichst dauerhafte und stabile Ausbildung der Ankopplung der Faser ermöglicht. Die Bezugsziffer 21 bezeichnet eine UV-Harzverbindung zur mechanisch stabilen Festlegung der Ankopplung der Faser an den Halbleiterchip. Die Oberfläche der Begrenzungsfläche 15 des Halbleiterchips 12 ist fast annähernd entspiegelt, d.h. sie besitzt einen so geringen Reflexionsgrad, daß eine hinreichende Laserfunktion gerade noch gewährleistet ist. Demgegenüber ist die Begrenzungsfläche 14 mit einer für das Laserlicht hochreflektiven Oberfläche versehen. Auf diese Weise wird ein möglichst hoher Anteil der vom Lichtwellenleiter 16 einfallenden Strahlung von der Halbleiterlaser- und Empfangsdiode 13 empfangen. Ein zur Anpassung des optischen Lichtausgangsfeldes dienender Feldtransformator, welcher zwischen dem lichtaussendenden Ende 22 des Halbleiterlasers und der dem Ende des Lichtwellenleiters zugewandten Begrenzungsfläche 15 angeordnet ist, ist mit der Bezugsziffer 23 schematisch angedeutet.

Fig. 4 zeigt ein weiteres Ausführungsbeispiel einer erfindungsgemäßen optoelektronischen Sende-Empfangs-Vorrichtung 1 mit einem DFB-Laser, bei dem die Ankopplung des Faserendes 18 an den Halbleiterchip 12 in Intra-Chip-Kopplung ausgebildet ist. Hierbei ist das Faserende 18 vollständig innerhalb einer in dem Halbleiterchip 12 ausgebildeten Vertiefung bzw. Nut 24 befestigt. Die Vertiefung 24 kann wie in Fig. 4 dargestellt eine der zylindrischen Form des Lichtwellenleiters 16 entsprechende Gestaltung besitzen, oder, zur besseren mechanischen Befestigung, eine V-förmig oder dergleichen verjüngende Gestalt annehmen. Zwischen der stirnseitigen Begrenzungsfläche 25 am Boden der Vertiefung 24 des Halbleiterchips 12 und der stirnseitigen Begrenzungsfläche 19 des Faserendes 18 wird wiederum eine dünne Anpassungsschicht 20 mit den bei der Erläuterung des Ausführungsbeispieles gemäß Fig. 3 angegebenen Eigenschaften angebracht.

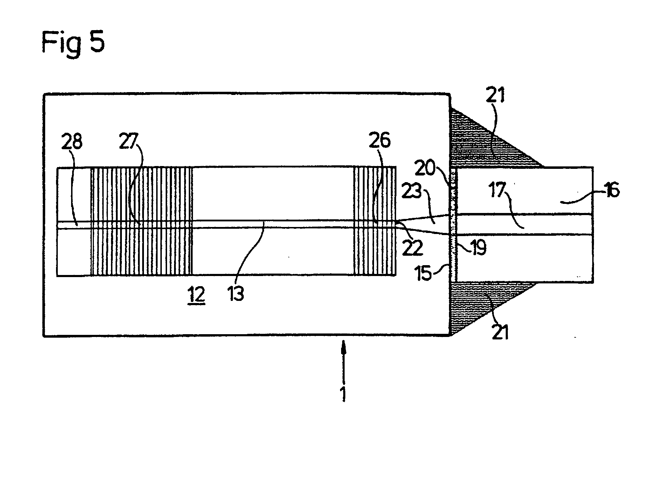

Fig. 5 zeigt ein weiteres Ausführungsbeispiel einer erfindungsgemäßen optoelektronischen Sende-Empfangs-Vorrichtung 1 mit einer DBR-Laser-Empfangsdiode 13, deren dem Lichtwellenleiter 16 zugewandtes Ende 26 niedrigreflektierend und deren hierzu gegenüberliegend angeordnetes Ende 27 hochreflektierend ausgebildet ist. Der DBR-Laser-Empfangsdiode 13 ist eine ebenfalls in dem Halbleiterchip 12 integriert ausgebildete Monitordiode 28 zugeordnet, welche aus dem empfangenen Signal eine Steuergröße zur selbsttätigen Steuerung des Sendestromes des Lasers liefert.

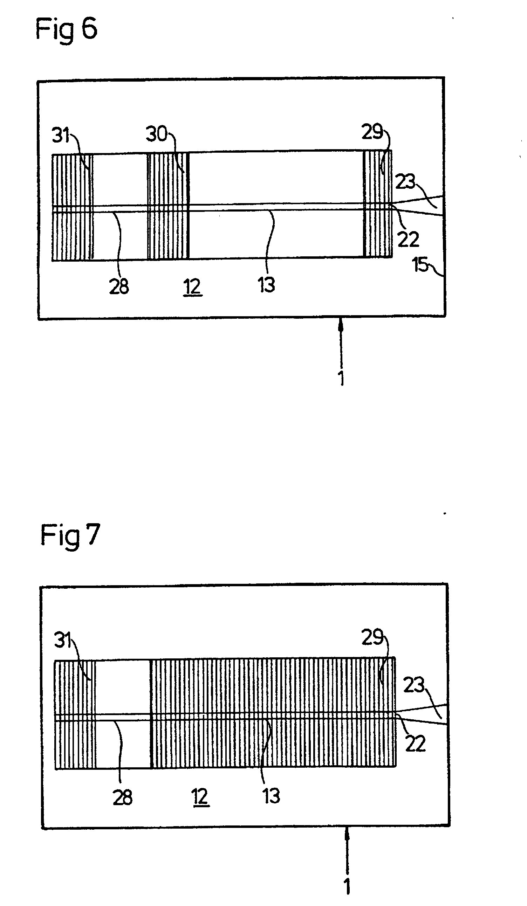

Die Fig. 6 und Fig. 7 zeigen besonders vorteilhafte Ausführungsformen mit einer Laser- und Empfangsdiode 13, bei denen zwei dicht benachbarte Wellenlängen verwendet werden, die im Verstärkungsfenster des Lasers liegen, jedoch durch Reflektoren getrennt werden können. Die Wellenlänge λ1 dient hierbei zum Senden, die Wellenlänge λ2 zum Empfangen. Bei der Ausführungsform gemäß Fig. 6 mit einer DBR-Laser- und Empfangsdiode 13 und einer dieser nachgeschalteten Monitordiode 28 sind Reflektoren 29, 30 und 31 in der Form von Gitterreflektoren innerhalb des Halbleiterchips 12 derart ausgebildet bzw. beschaffen, daß die zum Senden dienende Strahlung mit der Wellenlänge λ1 an dem Laserreflektor 29 mit geringem Reflexionsgrad und an dem Laserreflektor 30 mit hohem Reflexionsgrad gespiegelt wird, und die für den Empfang dienende Strahlung mit der Wellenlänge λ2 am Reflektor 31 der Monitordiode 28 hoch reflektiert wird, und an den Laserreflektoren 29 und 30 im wesentlichen nicht reflektiert wird. Auf diese Weise kann im Empfangsfall die Lichtstrahlung mit der Wellenlänge λ2 die für den Laserbetrieb erforderlichen Gitterreflektoren 29 und 30 auf beiden Seiten der Laserdiode ungedämpft passieren und am Ende der Anordnung durch den Reflektor 31 zur Erhöhung des Empfangswirkungsgrades reflektiert werden.

Fig. 7 zeigt eine vergleichbare Anordnung unter Verwendung einer DFB-Laser- und Empfangsdiode 13 und einer Monitordiode 28.

## Patentansprüche

1. Optoelektronische Sende-Empfangs-Vorrichtung (1) mit einer in einem Halbleiterchip (12) monolithisch integriert ausgebildeten Halbleiterlaser- und Empfangsdiode (12), deren Laserresonator durch die beiden äußeren, einander gegenüberliegend angeordneten Begrenzungsflächen (14, 15) des Halbleiterchips (12) ausgebildet ist, wobei das vom Halbleiterlaser ausgesandte Laserlicht in einen an der einen, lichtwellenleiterseitigen Begrenzungsfläche des Halbleiterchips (12) angekoppelten Lichtwellenleiter (16) einfällt,
**dadurch gekennzeichnet, daß**
die Ankopplung des Lichtwellenleiters (16) an die im Halbleiterchip (12) monolithisch integriert ausgebildete Halbleiterlaser- und Empfangsdiode (13) derart ausgebildet und die lichtwellenleiterseitige Begrenzungsfläche (15) des Halbleiterchips (12) so beschaffen ist, daß bei einem für die ausreichende Gewährleistung der Laserfunktion erforderlichen hinreichend geringen Reflexionsgrad der vom Laser ausgesandten Laserstrahlung ein möglichst hoher Anteil der über den Lichtwellenleiter (16) empfangenen Strahlung in die Halbleiterlaser- und Empfangsdiode (13) einfällt, daß der Ankopplung des Lichtwellenleiters (16) an die lichtwellenleiterseitige Begrenzungsfläche (15) des Halbleiterchips (12) eine dünne, auf einer dem Lichtwellenleiter (16) zugewandten Oberfläche der lichtwellenleiterseitigen Begrenzungsfläche (15) des Halbleiterchips (12) aufgebrachte Anpassungsschicht (20) zugeordnet ist, welche Anpassungsschicht (20) so beschaffen bzw. ein solches Material aufweist, daß. ein möglichst hoher Anteil der über den Lichtwellenleiter (16) empfangenen Strahlung in die Halbleiterlaser- und Empfangsdiode (13) einfällt, und daß das Material der Anpassungsschicht (20) einen Brechungsindex von etwa dem geometrischen Mittel der Werte des Brechungsindex des Materials der Halbleiterlaser- und Empfangsdiode (13) und des Brechungsindex des Materials des Lichtwellenleiters (16) besitzt.

2. Optoelektronische Sende-Empfangs-Vorrichtung (1) nach Anspruch 1; **dadurch gekennzeichnet, daß** die lichtwellenleiterseitige Begrenzungsfläche (15) des Halbleiterchips eine im wesentlichen fast annähernd vollständig entspiegelte Oberfläche bzw. eine eine im wesentlichen fast annähernd vollständige optische Durchlässigkeit für die über den Lichtwellenleiter (16) empfangene Strahlung aufweisende Oberfläche besitzt.

3. Optoelektronische Sende-Empfangs-Vorrichtung (1) nach Anspruch 1 oder 2, **dadurch gekennzeichnet, daß** der Brechungsindex des Halbeiterchipmaterials in dem Bereich von etwa 3,3 bis etwa 3,8 liegt und der Brechungsindex des Materials des Lichtwellenleiters (16) in dem Bereich von etwa 1,4 bis etwa 1,6 liegt.

4. Optoelektronische Sende-Empfangs-Vorrichtung (1) nach einem der Ansprüche 1 bis 3, **dadurch gekennzeichnet, daß** das Material der Anpassungsschicht (20) einen geringen optischen Absorptionskoeffizienten besitzt.

5. Optoelektronische Sende-Empfangs-Vorrichtung (1) nach einem der vorhergehenden Ansprüche, **dadurch gekennzeichnet, daß** die dem Lichtwellenleiter (16) abgewandte Begrenzungsfläche (14) des Halbleiterlasers (7) mit einer für das Laserlicht hoch reflektierenden Oberfläche versehen ist.

6. Optoelektronische Sende-Empfangs-Vorrichtung (1) nach einem der vorhergehenden Ansprüche, **dadurch gekennzeichnet, daß** zwischen dem lichtaussendenden Ende (22) des Halbleiterlasers (7) und der dem Ende des Lichtwellenleiters (22) zugewandten Begrenzungsfläche des Halbleiterchips (12) ein Feldtransformator (23) zur Anpassung des optischen Lichtausgangsfeldes von den räumlichen Abmessungen der Lichtaustrittsfläche des Lasers (7) an die Eintrittsfläche des angekoppelten Lichtwellenleiters (16) vorgesehen ist.

7. Optoelektronische Sende-Empfangs-Vorrichtung (1) nach einem der vorhergehenden Ansprüche, **dadurch gekennzeichnet, daß** integriert auf dem Halbleiterchip (12) eine der Regelung der Ausgangsleistung des Halbleiterlasers (7) zugeordnete Monitordiode (28) vorgesehen ist.

8. Optoelektronische Sende-Empfangs-Vorrichtung (1) nach einem der vorhergehenden Ansprüche, **dadurch gekennzeichnet, daß** die in dem Halbleiterchip (12) monolithisch integriert ausgebildete Halbleiterlaser- und Empfangsdiode (13) einen Laser mit einer DFB- oder einer DBR-Anordnung mit einem Braggitter aufweist.

9. Optoelektronische Sende-Empfangs-Vorrichtung (1) nach einem der vorhergehenden Ansprüche, **dadurch gekennzeichnet, daß** die in dem Halbleiterchip (12) monolithisch integriert ausgebildete Halbleiterlaser- und Empfangsdiode (13) beim Sendebetrieb mit Licht einer ersten Wellenlänge, und beim Empfangsbetrieb mit Licht einer zweiten, von der ersten unterschiedlichen Wellenlänge arbeitet.

10. Optoelektronische Sende-Empfangs-Vorrichtung (1) nach Anspruch 9, **dadurch gekennzeichnet, daß** die erste und die zweite Wellenlänge dicht benachbart zueinander liegen.

11. Optoelektronische Sende-Empfangs-Vorrichtung (1) nach Anspruch 9 oder 10, **dadurch gekennzeichnet, daß** der Trennung der beiden Strahlungen mit unterschiedlichen Wellenlängen eine in dem Halbleiterchip (12) integriert ausgebildete Gitterreflektoreinrichtung (29, 30, 31) zugeordnet ist.

12. Optoelektronische Sende-Empfangs-Vorrichtung (1) nach einem der Ansprüche 9 bis 11, **dadurch gekennzeichnet, daß** bei dem Empfangsbetrieb das Licht der zweiten Wellenlänge im wesentlichen ungedämpft die für den Laserbetrieb erforderlichen Gitterreflektoren (29, 30) auf beiden Seiten der Laserdiode (13) passiert.

13. Optoelektronische Sende-Empfangs-Vorrichtung (1) nach einem der Ansprüche 9 bis 12, **dadurch gekennzeichnet, daß** eine Reflektoranordnung (31) an einem Ende des Halbleiterlasers (7) vorgesehen ist, welche für das Licht der zweiten Wellenlänge einen hohen Reflexionsgrad aufweist.

14. Optoelektronische Sende-Empfangs-Vorrichtung (1) nach einem der vorhergehenden Ansprüche, **dadurch gekennzeichnet, daß** das Material des Halbleiterchips (12) ein III-V-Halbleiter ist, vorzugsweise InGaAsP auf InP-Substrat.

## Claims

1. Optoelectronic transceiver (1) having a semiconductor laser and receiving diode (12) which is designed to be monolithically integrated in a semiconductor chip (12) and whose laser resonator is formed by two outer bounding surfaces (14, 15), arranged opposite one another, of the semiconductor chip (12), the laser light emitted by the semiconductor laser impinging on an optical conductor (16) coupled to one bounding surface, on the optical conductor side, of the semiconductor chip (12), **characterized in that** the coupling of the optical conductor (16) to the semiconductor laser and receiving diode (13) designed to be monolithically integrated in the semiconductor chip (12) is constructed in such a way, and the bounding surface (15) on the optical conductor side, of the semiconductor chip (12) is fashioned such that, given that the laser radiation emitted by the laser has a reflecting coefficient small enough to adequately ensure functioning of the laser, as high as possible a fraction of the radiation received via the optical conductor (15) impinges on the semiconductor laser and receiving diode (13), **in that** the coupling of the optical conductor (16) to the bounding surface (15), on the optical conductor side, of the semiconductor chip (12) is assigned a thin adaptation layer (20) which is applied to a surface, facing the optical conductor (16), of the bounding surface (15), on the optical conductor side, of the semiconductor chip (12) and is fashioned, or has a material, such that as high as possible a fraction of the radiation received via the optical conductor (16) impinges on the semiconductor laser and receiving diode (13), and **in that** the material of the adaptation layer (20) has a refractive index of approximately the geometric mean of the values of the refractive index of the material of the semiconductor laser and receiving diode (13) and the refractive index of the material of the optical conductor (16).

2. Optoelectronic transceiver (1) according to Claim 1, **characterized in that** the bounding surface (15), on the optical conductor side, of the semiconductor chip has a surface having a substantially virtually completely antireflection-coated surface or a substantially virtually complete optical transparency to the radiation received via the optical conductor (15).

3. Optoelectronic transceiver (1) according to Claim 1 or 2, **characterized in that** the refractive index of the semiconductor chip material is in the range of approximately 3.3 to approximately 3.8, and the refractive index of the material of the optical conductor (16) is in the range of approximately 1.4 to approximately 1.6.

4. Optoelectronic transceiver (1) according to one of Claims 1 to 3, **characterized in that** the material of the adaptation layer (20) has a low optical absorption coefficient.

5. Optoelectronic transceiver (1) according to one of the preceding claims, **characterized in that** the bounding surface (14), averted from the optical conductor (16), of the semiconductor laser (7) is provided with a surface highly reflecting to laser light.

6. Optoelectronic transceiver (1) according to one of the preceding claims, **characterized in that** a field transformer (23) for adapting the optical light output field of the spatial dimensions of the light exit surface of the laser (7) to the entry surface of the coupled optical conductor (16) is provided between the light emitting end (22) of the semiconductor laser (7) and the bounding surface, facing the end of the optical conductor (22), of the semiconductor chip (12).

7. Optoelectronic transceiver (1) according to one of the preceding claims, **characterized in that** arranged integrated on the semiconductor chip (12) is a monitor diode (28) assigned to controlling the output power of the semiconductor laser (7).

8. Optoelectronic transceiver (1) according to one of the preceding claims, **characterized in that** the semiconductor laser and receiving diode (13) designed to be monolithically integrated in the semiconductor chip (12) has a laser with a DFB or DBR arrangement with a Bragg grating.

9. Optoelectronic transceiver (1) according to one of the preceding claims, **characterized in that** the semiconductor laser and receiving diode (13) designed to be monolithically integrated in the semiconductor chip (12) operates in transmit mode with light of a first wavelength, and in receive mode with light of a second wavelength, which differs from the first.

10. Optoelectronic transceiver (1) according to Claim 9, **characterized in that** the first and the second wavelengths are closely adjacent to one another.

11. Optoelectronic transceiver (1) according to Claim 9 or 10, **characterized in that** the separation of the two beams of different wavelengths is assigned a grating reflector device (29, 30, 31) designed to be integrated in the semiconductor chip (12).

12. Optoelectronic transceiver (1) according to one of Claims 9 to 11, **characterized in that** in the receive mode the light of the second wavelength passes substantially without attenuation the grating reflectors (29, 30), required for laser operation, on both sides of the laser diode (13).

13. Optoelectronic transceiver (1) according to one of Claims 9 to 12, **characterized in that** provided at one end of the semiconductor laser (7) is a reflector arrangement (31) which has a high reflecting coefficient for the light of the second wavelength.

14. Optoelectronic transceiver (1) according to one of the preceding claims, **characterized in that** the material of the semiconductor chip (12) is a III-V semiconductor, preferably InGaAsP on an InP substrate.

## Revendications

1. Dispositif (1) émetteur-récepteur optoélectronique comprenant une diode (12) laser semiconducteur et de réception qui est intégrée monolithiquement dans une puce (12) à semiconducteur et dont le résonateur laser est constitué par les deux faces (14, 15) extérieures de délimitation disposées en face l'une de l'autre de la puce (12) à semiconducteur, la lumière laser émise par le laser à semiconducteur entrant dans un guide (16) d'onde lumineuse couplé à l'une des faces de délimitation du côté du guide d'ondes de lumière de la puce (12) à semiconducteur
**caractérisé en ce que**
le couplage du guide (16) d'ondes de lumière à la diode (13) laser à semiconducteur et de réception intégré monolithiquement à la puce (12) à semiconducteur est constitué de sorte que, et la face (15) de la puce (12) à semiconducteur de délimitation du côté du guide d'ondes de lumière est telle que, pour un degré de réflexion suffisamment petit nécessaire pour assurer de manière suffisante la fonction de laser du faisceau laser émis par le laser, une proportion aussi grande que possible du faisceau reçu par le guide (16) d'ondes de lumière entre dans la diode (13) laser à semiconducteur et de réception, **en ce qu'**au couplage du guide (16) d'ondes de lumière à la surface (15) de la puce (12) à semiconducteur de délimitation du côté du guide d'ondes de lumière est associée une mince couche (20) d'adaptation déposée sur une surface, toumée vers le guide (16) d'ondes de lumière, de la face (15) de la puce (12) à semiconducteur de délimitation du côté du guide d'ondes de lumière, couche (20) d'adaptation qui est telle ou qui comprend une matière telle qu'une proportion aussi grande que possible du rayonnement reçu par le guide (16) d'ondes de lumière entre dans la diode (13) laser à semiconducteur et de réception et **en ce que** la matière de la couche (20) d'adaptation a un indice de réfraction à peu près égal à la moyenne géométrique des valeurs de l'indice de réfraction de la matière de la diode (13) laser à semiconducteur et de réception, et de l'indice de réfraction de la matière du guide (16) d'ondes de lumière.

2. Dispositif (1) émetteur-récepteur optoélectronique suivant la revendication 1, **caractérisé en ce que** la face (13) de la puce à semiconducteur de délimitation du côté du guide d'ondes de lumière a une surface sensiblement presque complètement antireflets ou une surface présentant une transparence optique sensiblement presque complète pour le rayonnement reçu par l'intermédiaire du guide (16) d'ondes de lumière.

3. Dispositif (1) émetteur-récepteur optoélectronique suivant la revendication 1 ou 2, **caractérisé en ce que** l'indice de réfraction de la matière de la puce à semiconducteur est de l'ordre d'environ 3,3 à environ 3,8 et l'indice de réfraction de la matière du guide (16) d'ondes de lumière est de l'ordre d'environ 1,4 à 1,6.

4. Dispositif (1) émetteur-récepteur optoélectronique suivant la revendication 1 à 3, **caractérisé en ce que** la matière de la couche (20) d'adaptation a un coefficient d'absorption optique qui est petit.

5. Dispositif (1) émetteur-récepteur optoélectronique suivant l'une des revendications précédentes, **caractérisé en ce que** la face (14) du laser (7) à semiconducteur de délimitation éloignée du guide (16) d'ondes de lumière est munie d'une surface très réfléchissante pour la lumière laser.

6. Dispositif émetteur-récepteur optoélectronique suivant l'une des revendications précédentes, **caractérisé en ce qu'**il est prévu entre l'extrémité (22) émettant de la lumière du laser (7) à semiconducteur et la face de la puce (12) à semiconducteur de délimitation tournée vers l'extrémité du guide (22) d'ondes de lumière, un transformateur (23) de champ destiné à adapter le champ optique de sortie de la lumière par les dimensions géométriques sur la face de sortie de la lumière du laser (7) à la face d'entrée du guide (16) d'ondes de lumière qui est couplé.

7. Dispositif émetteur-récepteur optoélectronique suivant l'une des revendications précédentes, **caractérisé en ce qu'**il est prévu, intégré à la puce (12) à semiconducteur, une diode (28) de moniteur associée à la régulation de la puissance de sortie du laser (7) à semiconducteur.

8. Dispositif émetteur-récepteur optoélectronique suivant l'une des revendications précédentes, **caractérisé en ce que** la diode (13) laser à semiconducteur et de réception intégrée monolithiquement à la puce (12) à semiconducteur comprend un laser ayant un dispositif DFB ou un dispositif DBR à réseau de Bragg.

9. Dispositif émetteur-récepteur optoélectronique suivant l'une des revendications précédentes, **caractérisé en ce que** la diode (13) laser à semiconducteur et de réception intégrée monolithiquement à la puce (12) à semiconducteur opère en fonctionnement en émission avec de la lumière d'une première longueur d'onde et en fonctionnement en réception avec de la lumière d'une deuxième longueur d'onde différente de la première.

10. Dispositif émetteur-récepteur optoélectronique suivant la revendication 9, **caractérisé en ce que** la première et la deuxième longueurs d'onde sont étroitement voisines.

11. Dispositif émetteur-récepteur optoélectronique suivant la revendication 9 ou 12, **caractérisé en ce qu'**à la séparation des deux faisceaux de longueurs d'onde différentes est associé un dispositif (29, 30, 31) réflecteur à réseau intégré à la puce (12) à semiconducteur.

12. Dispositif émetteur-récepteur optoélectronique suivant l'une des revendications 9 à 11, **caractérisé en ce qu'**en fonctionnement en réception, la lumière de la deuxième longueur d'onde passe sensiblement sans atténuation les réflecteurs (29, 30) à réseau nécessaires pour le fonctionnement à laser des deux côtés de la diode (13) laser.

13. Dispositif émetteur-récepteur optoélectronique suivant l'une des revendications 9 à 12, **caractérisé en ce qu'**il est prévu un dispositif (31) formant réflecteur à une extrémité du laser (7) à semiconducteur, dispositif qui a un grand degré de réflexion de la lumière de la deuxième longueur d'onde.

14. Dispositif émetteur-récepteur optoélectronique suivant l'une des revendications précédentes, **caractérisé en ce que** la matière de la puce (12) è semiconducteur est un semiconducteur III-V, de préférence de l'IngGaAsP sur un substrat en InP.
